# EUROPÄISCHE PATENTSCHRIFT

(11) **EP 2 134 990 B1**
(45) Veröffentlichungstag und Bekanntmachung des Hinweises auf die Patenterteilung: **21.09.2011**
(21) Anmeldenummer: 08734401.6
(22) Anmeldetag: 19.03.2008
(51) Int. Cl.: F16H 61/00, G12B 9/08, G01D 11/24, H05K 5/00

(54) **GEHÄUSE MIT VORRICHTUNG ZUM FIXIEREN EINES ELEKTRONISCHEN BAUTEILS**
HOUSING COMPRISING A DEVICE FOR FIXING AN ELECTRONIC COMPONENT
BOÎTIER AVEC DISPOSITIF POUR FIXER UN COMPOSANT ÉLECTRONIQUE

(30) Priorität: 19.03.2007 DE 102007013696
(43) Veröffentlichungstag der Anmeldung: 23.12.2009
(73) Patentinhaber: Conti Temic Microelectronic GmbH, 90411 Nürnberg (DE)
(72) Erfinder: BÜYÜKBAS, Turhan, 95158 Kirchenlamitz (DE); RIETSCH, Jürgen, 95030 Hof (DE); KARRER, Helmut, 90762 Fürth (DE); HENNIGER, Jürgen, 91056 Erlangen-Dechsendorf (DE); GRAMANN, Matthias, 77871 Renchen (DE); WIECZOREK, Matthias, 91223 Neunkirchen am Sand (DE); SCHARRER, Klaus, 91224 Hohenstadt (DE); GUTH, Peter, 90419 Nürnberg (DE); TRODLER, Dirk, 90489 Nürnberg (DE)
(86) Internationale Anmeldenummer: PCT/DE2008/000463
(87) Internationale Veröffentlichungsnummer: WO 2008/113336

(56) Entgegenhaltungen:
- WO-A-2007/004462
- DE-A1- 3 718 172
- DE-A1- 10 348 358
- JP-A- 9 326 567

## Beschreibung

Die Erfindung betrifft ein Gehäuse mit einer Vorrichtung zum Fixieren eines elektronischen Bauteils gemäß dem Oberbegriff des unabhängigen Anspruchs 1.

Elektronische Bauteile, insbesondere Sensoren, werden im Bereich der Messtechnik, der allgemeinen Kontrolltechnik und auch insbesondere in der Kraftfahrzeugtechnik eingesetzt. Nachfolgend wird der Einfachheit halber an Stelle von elektronischen Bauteilen nur noch von Sensoren gesprochen, was aber andere elektronische Bauteile nicht ausschließen soll. In einem Motor oder in einem Getriebe sind die Sensoren oft aggressiven Medien , wie Getriebeölen, hohen Temperaturschwankungen und hohen mechanischen Belastungen ausgesetzt. Dabei erfassen sie unter anderem Größen wie Drucke, Drehzahlen oder Langenabmessungen. Dazu ist es in der Regel erforderlich, dass die Lage des Sensors zum zu sensierenden Teil exakt eingestellt ist und über die gesamte Lebensdauer auch beibehalten wird.

Die DE 37 18 172 A1 offenbart ein Gehäuse aus einem Gehäuseoberteil und einem Gehäuseunterteil zur Aufnahme eines elektronischen Bauelements. Am Gehäuseoberteil ist ein Steg angeordnet, der bei geschlossenem Gehäuse das elektronische Bauelement an das Gehäuseunterteil drückt. Gehäuseoberteil und Gehäuseunterteil sind durch ein Scharnier miteinander verbunden und im geschlossenen Zustand gegeneinander verrastet.

Die WO 2007/004462 A1 offenbart ein Gehäuse aus einem Gehäuseunterteil und einem Deckel zur Aufnahme einer Detektionsvorrichtung. Die Detektionsvorrichtung ist auf einer Leiterplatte angeordnet. Ein Überstand am Deckel drückt die Leiterplatte im Gehäuse durch elastische oder plastische Deformation gegen das Gehäuseunterteil, um die Leiterplatte zu fixieren und zu positionieren.

Die JP 9 325657 A offenbart ähnlich wie die WO 2007/004462 A1 ein Gehäuse aus einem Gehäuseunterteil und einem DeckeL Ein Überstand am Deckel drückt eine Leiterplatte im Gehäuse gegen das Gehäuseunterteil, um die Leiterplatte zu positionieren. Der Deckel und das Gehäuseunterteil sind im geschlossenen Zustand gegeneinander verrastet.

Darüber hinaus darf eine bestimmte Kraft beim Fixieren des Sensors in seiner Aufnahme nicht überschritten werden, da, dieses oft druckempfindlich ist und bei zu hohen einwirkenden Kräften beschädigt werden kann.

Zu diesem Zweck sind die Sensoren mit einem Gehäuse ummantelt, wobei das Gehäuse ein Unterteil und einen Deckel umfasst, beide vorzugsweise aus Kunst stoff. Üblicherweise werden die Sensoren im Unterteil verkippsicher aufgenommen und nachträglich zur mechanischen Fixierung spielfrei mit einem Deckel abgedeckt. Anschließend werden Unterteil und Deckel form-, kraft- oder stoffschlüssig miteinander verbunden.

Bisher geschieht dies beispielsweise entweder in Kombination mit einem System aus Rastnase und Rasttasche am Unterteil und am Deckel mit anschließender Verstemmung der beiden Teile; sei es warm oder kalt An Stelle der Verstemmung kann der Deckel mit dem Unterteil auch mittels einer Schweißung verbunden werden, sei es durch Ultraschall oder Laserstrahlen. Weiterhin gibt es Anwendungen, wobei das Unterteil und der Deckel nach dem Einsetzen des Sensors in das Unterteil mittels einer Gesamtumspritzung miteinander verbunden werden.

Nachteilig an den bisherigen Gehäusen ist, das zu dessen Fertigstellung eine relativ große Anzahl an Prozessen nötig ist: Einsetzen des Sensors in das Unterteil, Abdecken des Sensors und gleichzeitige Fixierung des Sensors durch den Deckel und abschließende Herstellung des Gesamtverbundes Unterteil und Deckel. Zudem sind nach der Fertigstellung Unterteil und Deckel unlösbar miteinander verbunden.

Es ist daher die Aufgabe der Erfindung, ein Gehäuse der eingangs genannten Art derart zu schaffen, dass der Sensor im Gehäuse über die gesamte Lebensdauer lagestabil und funktionssicher aufgenommen ist, wobei der Verbund aus dem Deckel mit Unterteil des Gehäuses dauerhaft stabil und einfach herstellbar ist.

Diese Aufgabe wird erfindungsgemäß gelöst durch ein Gehäuse gemäß den Merkmalen des Anspruchs 1.

Der Kern der Erfindung besteht darin, dass der Deckel des Gehäuses derart beschaffen ist, dass der Deckel im montierten Zustand am elektronischen Bauteil derart vorgespannt anliegt, dass die anliegende Kraft in einem vorgegebenen Kraftbereich liegt, insbesondere eine bestimmte Maximalkraft nicht übersteigt. Dadurch wird das elektronische Bauteil unter Beibehaltung seiner Funktionalität über die gesamte Lebensdauer lagestabil fixiert und zusätzlich werden die Auswirkungen eventueller Sensorhöhentoleranzen auf die Anordnung des Sensors im Gehäuse kompensiert. Weiterhin ist der Deckel mit dem Unterteil mittels einer Klemmgeometrie verbunden ist Die Klemmgeometrie umfasst eine Nut am Unterteil und einen in die Nut eingreifenden Steg am Deckel, wobei eine Klemmrippe am Unterteil oder am Deckel derart angeordnet ist, dass der Deckel nach der Verbindung mit dem Unterteil mit einer Klemmkraft an das Unterteil geklemmt ist, die parallel zur am elektronischen Bauteil anliegenden Kraft wirkt. Vorteilhafterweise ist es dadurch auch möglich, dass der Deckel zum Beispiel zu Reparaturzwecken vom Unterteil wieder entfernt werden kann.

Insbesondere liegt die Kraft, mit der der Deckel am elektronischen Bauteil anliegt, zwischen einer minimalen Kraft, die mindestens nötig ist, um das elektronische Bauteil im Gehäuse zu fixieren, und einer maximalen Kraft , die zur Sicherstellung der Funktionalität des elektronischen Bauteils nicht überschritten werden darf.

Die Kraft, mit der der Deckel am elektronischen Bauteil anliegt ist insbesondere mittels eines vorgegebenen Elastizitätsmoduls des Deckels oder mittels eines vorgegebenen Dickenprofils des Deckels einstellbar. Es wäre auch eine Kombination aus beiden Merkmalen denkbar. Der Deckel, in der Regel auch das Unterteil, ist vorzugsweise aus Polyamid oder einem anderen Polymer. Das Elastizitätsmodul des Deckels liegt insbesondere im Bereich zwischen 3 GPa und 10 GPa. Die Dicke des Deckels schwankt vorteilhafterweise zwischen 0,15 mm und 3,0 mm. Es wäre auch denkbar, dass die Deckeldicke ein sich von der Mitte nach außen verjüngendes Profil aufweist, oder umgekehrt.

Das Profil des Deckels ist beispielsweise planparallel, plan-konvex oder auch konkav-konvex ausgestaltet. Ein Vorteil einer in Richtung elektronisches Bauteil gewölbten Form des Deckelprofils ist, dass dadurch eine zusätzliche Vorspannung erzielt wird.

Die Klemmgeometrie, mittels der der Deckel mit dem Unterteil verbunden ist, umfasst im wesentlichen eine Nut, einen in die Nut eingreifenden Steg und eine an der Nut oder am Steg angeordnete Klemmrippe, die die Klemmkraft, mit der Deckel und Unterteil verbunden sind, bewirkt. Vorteilhafterweise erstreckt sich die Klemmrippe zur gleichmäßigen Verteilung der Klemmkraft über die gesamte Länge der Nut bzw. des Stegs. Die Klemmrippe könnte aber auch kürzer sein.

In der Regel wird der Deckel seitlich so auf das Unterteil geschoben oder gefügt, dass der Steg in die Nut eingreift, wobei beim Fügen die durch die Klemmrippe entstehende Klemmkraft überwunden werden muss. Insbesondere zeigt die Vorderseite der Klemmrippe, das heißt die in Fügerichtung vorne liegende Seite der Klemmrippe, einen sich verjüngenden, im wesentlichen keilförmigen Auslauf. Dadurch wird der Fügevorgang erleichtert und zusätzlich wirkt diese Ausgestaltungsform der Klemmrippe beim Lösen des Deckels vom Unterteil insbesondere selbsthemmend (?).

Weitere Vorteile und Merkmale der Erfindung ergeben sich aus der nachfolgenden Beschreibung eines Ausführungsbeispiels der Erfindung anhand der Zeichnungen. Es zeigen:
- Fig. 1: Explosionsdarstellung von Deckel, Sensor und Unterseite,
- Fig.2: Seitenansicht eines Gehäuses mit Deckel auf Unterteil montiert,
- Fig. 3: Räumliche Darstellung eines gewölbten Deckels,
- Fig. 4: Seitenansicht eines Deckels mit Klemmrippe mit Auslauf
- Fig. 5: Anordnung von zwei Sensoren in einem Unterteil mit zwei Sensorauf- nahmen und einem Deckel.

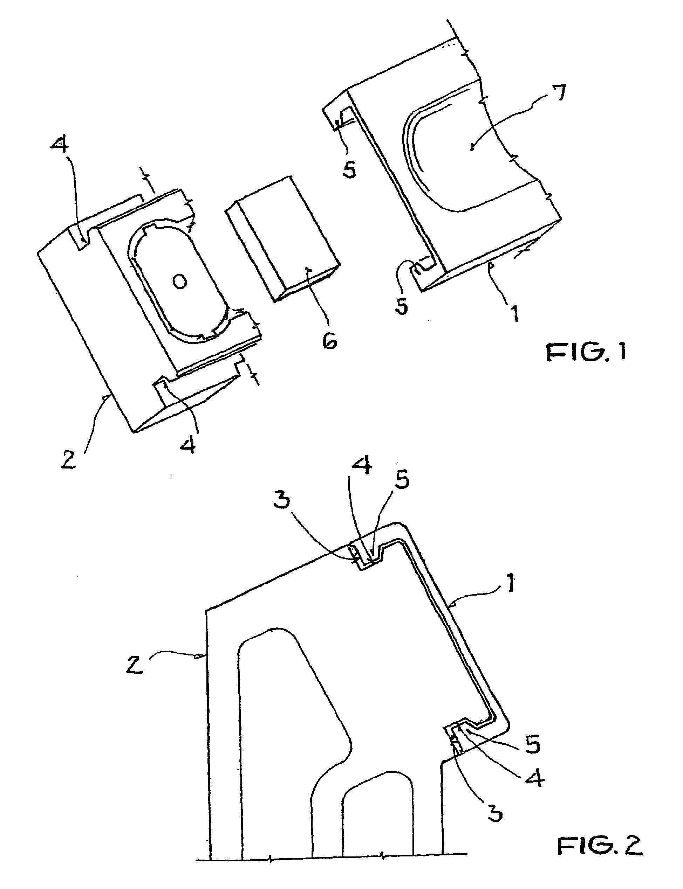

Fig. 1 zeigt eine Explosionsdarstellung eines Gehäuses zur Aufnahme eines Sensors 6 mit einem Deckel 1 und einem Unterteil 2. Der Deckel 1 weist ein in Richtung Sensor 6 gewölbtes, konkav-konvexes bzw. meniskusförmiges Profil 7 auf.
Fig. 2 zeigt eine Seitenansicht des Gehäuse aus Fig. 1 mit dem auf das Unterteil 2 gefügten, das heißt geschobenen, Deckel 1. Der Deckel 1 übt auf Grund seines Profils 7 auf den Sensor 6 eine Kraft F aus, die zwischen einer minimalen Kraft Fmin, die mindestens nötig ist, um den Sensor 6 im Gehäuse zu dauerhaft lagestabil zu fixieren, und einer maximalen Kraft Fmax liegt, die zur Sicherstellung der Funktionalität des Sensors 6 nicht überschritten werden darf.

An der Unterseite des Stegs 5, der in die Nut 4 des Unterteils 2 des Gehäuses eingreift, ist eine insbesondere streifenförmige Klemmrippe 3, mit zum Beispiel dreieckigem Querschnitt, angeordnet. Vorteilhafterweise erstreckt sich die Klemmrippe 3 über die gesamte Länge des Stegs 5, könnte aber auch bei Bedarf kürzer ausgeführt sein. Der Steg 5, die Nut 4 und die Klemmrippe 3 bilden die Klemmgeometrie, mittels der der Deckel 1 kraftschlüssig mit dem Unterteil 2 verbunden ist. Die Klemmkraft KF wirkt parallel zur am Sensor 6 anliegenden Kraft F. Insbesondere ist es durch diese derart gestaltete Klemmgeometrie möglich, dass der Deckel 1 zum Beispiel zu Reparaturzwecken vom Unterteil 2 wieder entfernt und nach der Reparatur wieder auf das Unterteil 2 gefügt werden kann. Die Klemmrippe 3 könnte auch an der Nut 4 des Unterteils 2 angeordnet sein. Es wäre auch denkbar, dass sowohl am Unterteil 2 als auch am Deckel 1 jeweils eine Klemmrippe 3 angeordnet ist.

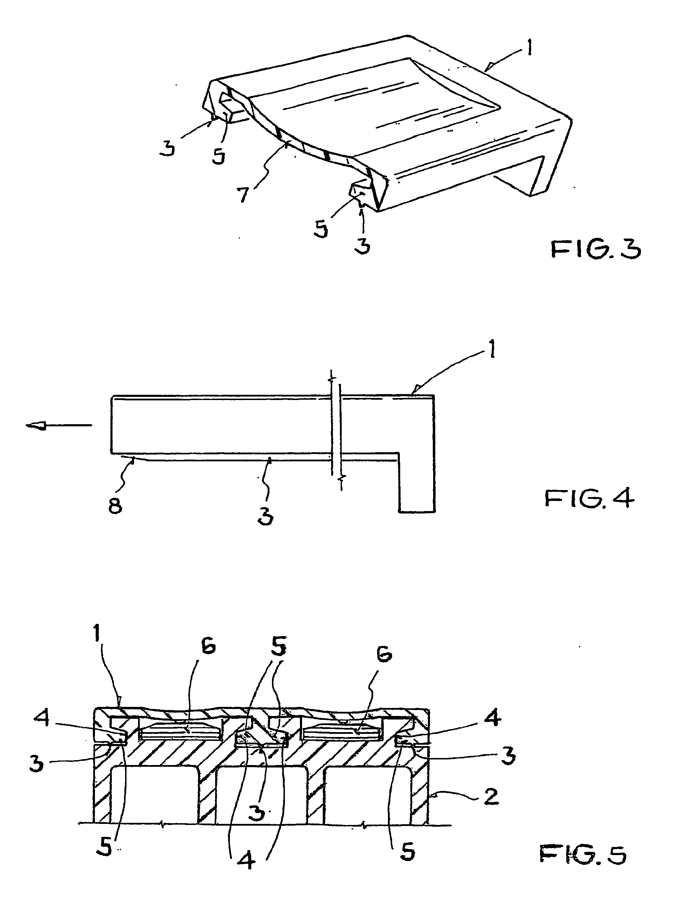

Fig. 3 zeigt eine räumliche Darstellung eines Deckels 1 mit einem konkavkonvexen, insbesondere einem meniskusförmigen Profil 7, das parallel zum Steg 5 des Deckels 1 verläuft. Es wäre auch denkbar, das Profil 7 zum Beispiel um 90 ° gedreht anzuordnen. Das Profil 7 muss sich auch nicht über die gesamte Fläche des Deckels 1 ausdehnen.
Fig. 4 zeigt eine Seitenansicht des Deckels 1. Die Klemmrippe 3 erstreckt sich hier über die gesamte Länge des Stegs 5 an der Unterseite des Deckels 1. Der Deckel 1 wird in der Regel seitlich so auf das Unterteil 2 geschoben oder gefügt, dass der Steg 5 in die Nut 4 eingreift, wobei beim Fügen die durch die Klemmrippe 3 entstehende Klemmkraft KF überwunden werden muss. Insbesondere zeigt die Vorderseite der Klemmrippe 3 in Fügerichtung einen sich verjüngenden, im wesentlichen keilförmigen Auslauf 8. Dadurch wird der Fügevorgang erleichtert und zusätzlich wirkt diese Ausgestaltungsform der Klemmrippe 3 beim Lösen des Deckels vom Unterteil insbesondere selbsthemmend.
Fig. 5 zeigt eine Anordnung von zwei Sensoren 6 in einem Unterteil 2 mit einem gemeinsamen Deckel 1, der zwischen den zwei Sensoren 6 einen insbesondere beidseitig ausgeformten Steg 5 mit mindestens einer Klemmrippe 3 aufweist. Natürlich könnte eine derartige Anordnung auch mehr als zwei Sensoren 6 aufnehmen

### Bezugszeichenliste:

- 1: Deckel
- 2: Unterteil
- 3: Klemmrippe
- 4: Nut
- 5: Steg
- 6: Sensor
- 7: Profil des Deckels
- 8: Auslauf an Klemmrippe

## Patentansprüche

1. Gehäuse zur Aufnahme eines elektronischen Bauteils (6), umfassend einen Deckel (1) und ein Unterteil (2) aus Kunststoff, wobei der Deckel (1) mit dem Unterteil (2) mittels einer Klemmgeometrie (3,4,5) kraftschlüssig verbunden ist und der Deckel (1) nach der Verbindung mit dem Unterteil (2) auf Grund seiner Beschaffenheit auf das elektronische Bauteil (6) eine vorgegebene Kraft (F) zur Lagefixierung des elektronischen Bauteils (6) ausübt, wobei der Deckel (1) im montierten Zustand am elektronischen Bauteil (6) vorgespannt anliegt, und wobei
- der Deckel (1) derart beschaffen ist, dass die anliegende Kraft (F) in einem vorgegebenen Kraftbereich (B) liegt, und
- die Klemmgeometrie eine Nut (4) am Unterteil (2) und einen in die Nut (4) eingreifenden Steg (5) am Deckel (1) umfasst,
**dadurch gekennzeichnet, dass** eine Klemmrippe (3) an der Nut (4) oder am Steg (5) derart
angeordnet ist, dass
der Deckel (1), der auf das Unterteil (2) seitlich so aufschiebbar ist, dass der Steg (5) in die Nut (4) eingreift, nach der Verbindung mit dem Unterteil (2) mit einer zur Kraft (F) parallel wirkenden Klemmkraft (KF) an das Unterteil (2) wieder lösbar geklemmt ist,
wobei die Klemmrippe (3) die Klemmkraft (KF) gewirkt, mit der Deckel (1) und Unterteil (2) verbunden sind.

2. Gehäuse nach Anspruch 1, **dadurch gekennzeichnet, dass** der Kraftbereich (B) zwischen einer minimalen Kraft (Fmin), die mindestens nötig ist, um das elektronische Bauteil (6) im Gehäuse zu fixieren, und einer maximalen Kraft (Fmax) liegt, die zur Sicherstellung der Funktionalität des elektronischen Bauteils (6) einzuhalten ist.

3. Gehäuse nach Anspruch 1 oder 2, **dadurch gekennzeichnet, dass** die vorgegebene Kraft (F), die der Deckel (1) auf das elektronische Bauteil (6) ausübt, durch ein vorgegebenes Elastizitätsmoduls (E) des Deckels (1) und/oder mittels eines vorgegebenen Profils (7) des Deckels (1) einstellbar ist.

4. Gehäuse nach einem der vorhergehenden Ansprüche, **dadurch gekennzeichnet, dass** das Profil (7) des Deckels (1) im wesentlichen planparallel ausgestaltet ist.

5. Gehäuse nach einem der Ansprüche 1 bis 3, **dadurch gekennzeichnet, dass** das Profil (7) des Deckels (1) im wesentlichen plan-konvex ausgestaltet ist.

6. Gehäuse nach einem der Ansprüche 1 bis 3, **dadurch gekennzeichnet, dass** das Profil (7) des Deckels (1) im wesentlichen konkav-konvex ausgestaltet ist.

7. Gehäuse nach einem der vorhergehenden Ansprüche, **dadurch gekennzeichnet, dass** sich die Klemmrippe (3) über die gesamte Länge der Nut (4) oder des Stegs (5) erstreckt.

8. Gehäuse nach einem der vorhergehenden Ansprüche, **dadurch gekennzeichnet, dass** die Klemmrippe (3) in Fügerichtung an einem Ende einen keilförmigen Auslauf (8) aufweist

## Claims

1. A housing for receiving an electronic component (6), comprising a cover (1) and a lower part (2) made of plastic, wherein the cover (1) is friction-locked to the lower part (2) by means of a clamping geometry (3, 4, 5) and the cover (1), after being connected to the lower part (2), due to its characteristics, exerts a predetermined force (F) onto the electronic component (6) in order to fix the electronic component (6) in position, wherein the cover (1) is pre-tensioned so as to contact the electronic component (6) in the mounted state, and wherein
- the cover (1) has such characteristics that the applied force (F) is in a predetermined force range (B), and
- the clamping geometry comprises a groove (4) on the lower part (2) and a ridge (5) which is arranged on the cover (1) and engages in the groove (4),
**characterized in that** a clamping rib (3) is arranged adjacent to the groove (4) or on the ridge (5) in such a manner that
the cover (1), which can be slid onto the lower part (2) from the side so that the ridge engages in the groove (4), after being connected to the lower part (2), is releasably clamped to the lower part (2) again with a clamping force (KF) acting parallel to the force (F),
wherein the clamping rib (3) produces the clamping force (KF) with which the cover (1) is connected to the lower part (2).

2. A housing according to claim 1, **characterized in that** the force range (B) is between a minimum force (Fmin), which is the minimum required to fix the electronic component (6) in the housing, and a maximum force (Fmax) which has to be observed to ensure proper functioning of the electronic component (6).

3. A housing according to claim 1 or 2, **characterized in that** the predetermined force (F) exerted by the cover (1) onto the electronic component (6) can be adjusted by means of a predetermined modulus of elasticity (E) of the cover (1) and/or by means of a predetermined profile (7) of the cover (1).

4. A housing according to any one of the preceding claims, **characterized in that** the profile (7) of the cover (1) is designed to be substantially plane-parallel.

5. A housing according to any one of claims 1 to 3, **characterized in that** the profile (7) of the cover (1) is designed to be substantially plane-convex.

6. A housing according to any one of claims 1 to 3, **characterized in that** the profile (7) of the cover (1) is designed to be substantially concave-convex.

7. A housing according to any one of the preceding claims, **characterized in that** the clamping rib (3) extends along the entire length of the groove (4) or the ridge (5).

8. A housing according to any one of the preceding claims, **characterized in that** the clamping rib (3), in the mounting direction, has a wedge-shaped end section (8) at one end.

## Revendications

1. Boîtier pour loger un composant électronique (6), comprenant un couvercle (1) et une partie inférieure (2) en matière plastique, le couvercle (1) étant raccordé par liaison de force à la partie inférieure (2) au moyen d'une géométrie de serrage (3, 4, 5), et le couvercle (1) exerçant, après le raccordement à la partie inférieure (2), en raison de sa nature, une force (F) prédéfinie sur le composant électronique (6) pour la fixation en position du composant électronique (6), le couvercle (1) à l'état monté appuyant, avec une prétension, contre le composant électronique (6), et
- le couvercle (1) étant réalisé de sorte que la force (F) d'appui se situe dans une plage de force (B) prédéfinie, et
- la géométrie de serrage comprenant une rainure (4) sur la partie inférieure (2) et une nervure (5), s'engageant dans la rainure (4) sur le couvercle (1), **caractérisé en ce qu'**une arête de serrage (3) est disposée sur la rainure (4) ou sur la nervure (5) de sorte que
le couvercle (1), qui peut coulisser latéralement sur la partie inférieure (2) de sorte que la nervure (5) s'engage dans la rainure (4), est, après le raccordement à la partie inférieure (2), serré de façon détachable sur la partie inférieure (2) avec une force de serrage (KF) agissant parallèlement à la force (F),
l'arête de serrage (3) provoquant la force de serrage (KF) avec laquelle le couvercle (1) et la partie inférieure (2) sont raccordés.

2. Boîtier selon la revendication 1, **caractérisé en ce que** la plage de force (B) se situe entre une force minimale (Fmin) qui est au moins nécessaire pour fixer le composant électronique (6) dans le boîtier, et une force maximale (Fmax) qui doit être maintenue pour assurer la fonctionnalité du composant électronique (6).

3. Boîtier selon la revendication 1 ou 2, **caractérisé en ce que** la force (F) prédéfinie qu'exerce le couvercle (1) sur le composant électronique (6) peut être réglée par un module d'élasticité (E) prédéfini du couvercle (1) et/ou au moyen d'un profil (7) prédéfini du couvercle (1).

4. Boîtier selon une des revendications précédentes, **caractérisé en ce que** le profil (7) du couvercle (1) est constitué de façon essentiellement plan-parallèle.

5. Boîtier selon une des revendications 1 à 3, **caractérisé en ce que** le profil (7) du couvercle (1) est constitué de façon essentiellement plan-convexe.

6. Boîtier selon une des revendications 1 à 3, **caractérisé en ce que** le profil (7) du couvercle (1) est constitué de façon essentiellement concave-convexe.

7. Boîtier selon une des revendications précédentes, **caractérisé en ce que** l'arête de serrage (3) s'étend sur toute la longueur de la rainure (4) ou de la nervure (5).

8. Boîtier selon une des revendications précédentes, **caractérisé en ce que** l'arête de serrage (3) présente, dans la direction d'assemblage, à une extrémité, une terminaison (8) en forme de coin.
